# EUROPEAN PATENT APPLICATION

(11) **EP 2 492 750 A1**
(43) Date of publication of application: **29.08.2012**
(21) Application number: 12157174.9
(22) Date of filing: 27.02.2012
(51) Int. Cl.: G03F 7/039, G03F 7/20

(54) **Photoresist compositions and methods of forming photolithographic patterns**

(30) Priority: 28.02.2011 US 201161447695 P
(71) Applicant: Rohm and Haas Electronic Materials LLC, Marlborough, MA 01752 (US)
(72) Inventor: Bae, Young Cheol, Weston, MA Massachusetts 02493 (US); Park, Jong Keun, Hudson, MA Massachusetts 01749 (US); Lee, Seung-Hyun, Marlborough, MA Massachusetts 01752 (US); Liu, Yi, Wayland, MA Massachusetts 01778 (US); Cardolaccia, Thomas, Needham, MA Massachusetts 02494 (US); Bell, Rosemary, Wayland, MA Massachusetts 01778 (US)
(74) Representative: Buckley, Guy Julian

(57) **Abstract**

Provided are photoresist compositions useful in forming photolithographic patterns. Also provided are substrates coated with the photoresist compositions and methods of forming photolithographic patterns. The compositions, methods and coated substrates find particular applicability in the manufacture of semiconductor devices.

## Description

### FIELD

The invention relates generally to the manufacture of electronic devices. More specifically, this invention relates to photoresist compositions, coated substrates and to photolithographic methods which allow for the formation of fine patterns using a negative tone development process.

### BACKGROUND

In the semiconductor manufacturing industry, photoresist materials are used for transferring an image to one or more underlying layers, such as metal, semiconductor and dielectric layers, disposed on a semiconductor substrate, as well as to the substrate itself. To increase the integration density of semiconductor devices and allow for the formation of structures having dimensions in the nanometer range, photoresists and photolithography processing tools having high-resolution capabilities have been and continue to be developed.

Positive-tone chemically amplified photoresists are conventionally used for high-resolution processing. Such resists typically employ a resin having acid-labile leaving groups and a photoacid generator. Exposure to actinic radiation causes the acid generator to form an acid which, during post-exposure baking, causes cleavage of the acid-labile groups in the resin. This creates a difference in solubility characteristics between exposed and unexposed regions of the resist in an aqueous alkaline developer solution. Exposed regions of the resist are soluble in the aqueous alkaline developer and are removed from the substrate surface, whereas unexposed regions, which are insoluble in the developer, remain after development to form a positive image.

One approach to achieving nm-scale feature sizes in semiconductor devices is the use of short wavelengths of light, for example, 193 nm or less, during exposure of chemically amplified photoresists. To further improve lithographic performance, immersion lithography tools have been developed to effectively increase the numerical aperture (NA) of the lens of the imaging device, for example, a scanner having a KrF or ArF light source. This is accomplished by use of a relatively high refractive index fluid (i.e., an immersion fluid) between the last surface of the imaging device and the upper surface of the semiconductor wafer. The immersion fluid allows a greater amount of light to be focused into the resist layer than would occur with an air or inert gas medium. When using water as the immersion fluid, the maximum numerical aperture can be increased, for example, from 1.2 to 1.35. With such an increase in numerical aperture, it is possible to achieve a 40 nm half-pitch resolution in a single exposure process, thus allowing for improved design shrink. This standard immersion lithography process, however, is generally not suitable for manufacture of devices requiring greater resolution, for example, for the 32 nm and 22 nm half-pitch nodes.

Considerable effort has been made to extend the practical resolution capabilities of positive tone development in immersion lithography from both a materials and processing standpoint. One such example involves negative tone development (NTD) of a traditionally positive-type chemically amplified photoresist. NTD allows for use of the superior imaging quality obtained with bright field masks for printing the critical dark field layers. NTD resists typically employ a resin having acid-labile (or acid-cleavable) groups and a photoacid generator. Exposure to actinic radiation causes the photoacid generator to form an acid which, during post-exposure baking, causes cleavage of the acid-labile groups giving rise to a polarity switch in the exposed regions. As a result, a difference in solubility characteristics is created between exposed and unexposed regions of the resist such that unexposed regions of the resist can be removed by particular developers, typically organic developers such as ketones, esters or ethers, leaving behind a pattern created by the insoluble exposed regions. Such a process is described, for example, in U.S. Patent No. 6,790,579, to Goodall et al. That document discloses a photoresist composition comprising an acid-generating initiator and a polycyclic polymer containing recurring acid labile pendant groups along the polymer backbone. The exposed areas can be selectively removed with an alkaline developer or, alternatively, the unexposed regions can be selectively removed by treatment with a suitable nonpolar solvent for negative tone development.

Conventional 193 nm photoresist polymers typically include alkyl adamantyl methacrylate units in which the alkyl adamantly moieties function as acid labile leaving groups. Such leaving groups, however, exhibit very slow dissolution rates in NTD developers such as 2-heptanone and n-butyl acetate (NBA). Low dissolution rates have been found to result in poor pattern fidelity. Increasing the dissolution rate of such polymers in an NTD developer can be accomplished by use of relatively low molecular weight polymers. This is not a viable total solution as lower molecular weight polymers have been found to exhibit poor photospeed and CD uniformity.

There is a continuing need in the art for improved photoresist compositions and photolithographic methods for negative tone development which allow for the formation of fine patterns in electronic device fabrication and which avoid or conspicuously ameliorate one or more of the foregoing problems associated with the state of the art.

### SUMMARY

In accordance with a first aspect of the invention, photoresist compositions are provided. The photoresist compositions comprise: a first polymer comprising units of the following general formulae (I), (II) and (III): 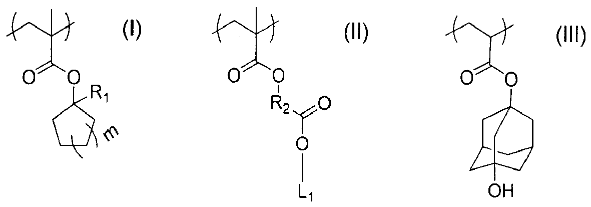 wherein: R₁ represents a C₁ to C₃ alkyl group; R₂ represents a C₁ to C₃ alkylene group; m represents 0 or 1; and L₁ represents a lactone group; a second polymer comprising units of the following general formulae (IV) and (V): 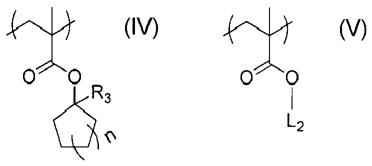 wherein: R₃ represents a C₁ to C₃ alkyl group; L₂ represents a lactone group; and n is 0 or 1; and a photoacid generator.

Also provided are coated substrates. The coated substrates comprise a substrate and a layer of a photoresist composition as described herein over a surface of the substrate.

Also provided are methods of forming photolithographic patterns. The methods comprise: (a) providing a substrate comprising one or more layer to be patterned over a surface of the substrate; (b) applying a layer of a photoresist composition as described herein over the one or more layer to be patterned; (c) patternwise exposing the photoresist composition layer to actinic radiation; (d) heating the exposed photoresist composition layer in a post-exposure bake process; and (e) applying a developer to the photoresist composition layer to remove a portion of the photoresist layer, thereby forming a photoresist pattern, wherein unexposed regions of the photoresist layer are removed by the developer to form the photoresist pattern.

Also provided are electronic devices formed by the methods described herein.

As used herein: "g" means grams; wt% means weight percent; "L" means liter; "mL" means milliliter; "nm" means nanometer; "mm" means millimeter; "min" means minute; "h" means hour; "Å" means Angstrom; "mol%" means mole percent; "ppb" means parts per billion; "Mw" means weight average molecular weight; and "Mn" means number average molecular weight; "PDI" means polydispersity index = Mw/Mn; "copolymer" is inclusive of polymers containing two or more different types of polymerized units; and the articles "a" and "an" are inclusive of one or more.

### BRIEF DESCRIPTION OF THE DRAWINGS

The present invention will be described with reference to the following drawings, in which like reference numerals denote like features, and in which:

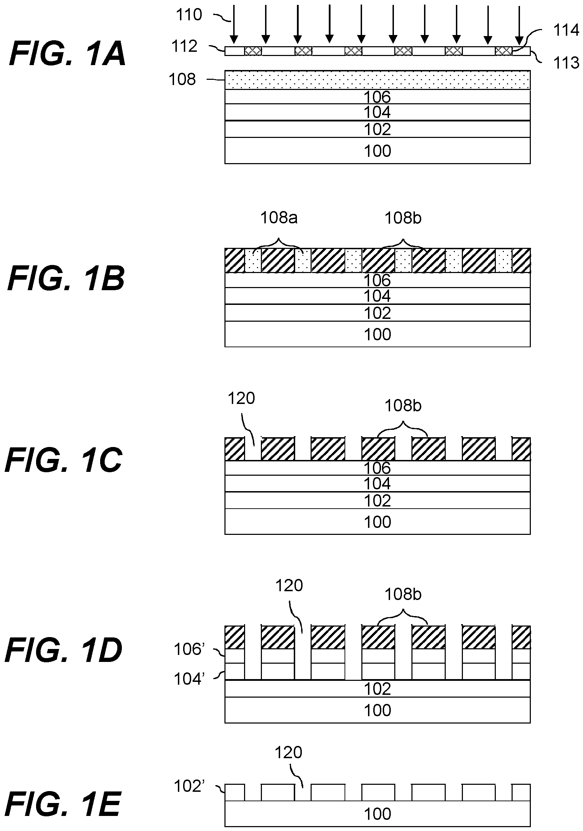

FIG. 1A-E illustrates a process flow for forming a photolithographic pattern in accordance with the invention.

### DETAILED DESCRIPTION

### Photoresist Compositions

The photoresist compositions of the invention include a first matrix polymer, a second matrix polymer and a photoacid generator, and can include various optional components. The photoresist compositions are chemically-amplified materials and are particularly suited for use in negative tone development processes.

Preferred photoresist compositions of the invention when used to form very fine patterns in a negative tone development process can provide improvements in one or more of resolution, top loss, focus latitude, exposure latitude and defectivity as compared with conventional positive-tone photolithographic techniques. Preferred photoresists of the invention can in particular provide improvements in contact hole circularity and CD uniformity. These benefits can be achieved when using the compositions in dry lithography or immersion lithography processes. When used in immersion lithography, preferred photoresist compositions can further exhibit reduced migration (leaching) of photoresist materials into an immersion fluid allowing for a topcoat-free process.

### A. First Polymer

The photoresist compositions include a first matrix polymer which is acid-sensitive. This means that the first matrix polymer as part of a layer of the photoresist composition undergoes a change in solubility in an organic developer as a result of reaction with acid generated from the photoacid generator following softbake, exposure to activating radiation and post exposure bake. The matrix polymer has a low glass transition temperature (T_{g}) relative to the second polymer and a high dissolution rate relative to the second polymer.

The first matrix polymer comprises units of the following general formulae (I), (II) and (III): 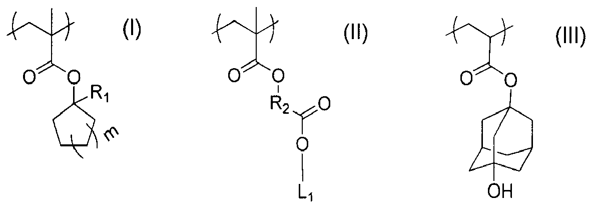 wherein: R₁ represents a C₁ to C₃ alkyl group; R₂ represents a C₁ to C₃ alkylene group; m represents 0 or 1; and L₁ represents a lactone group.

The unit of general formula (I) includes an acid labile group that undergoes a photoacid-promoted deprotection reaction on exposure to activating radiation and heat treatment. This allows for a switch in polarity of the matrix polymer, leading to a change in solubility of the polymer and photoresist composition in an organic developer. Suitable monomers for forming units of formula (I) include, for example, the following:

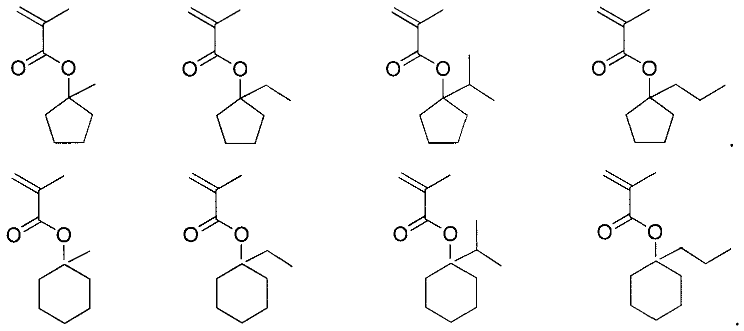

The unit of general formula (II) includes an extended lactone moiety effective to control the dissolution rate of the matrix polymer and photoresist composition. Suitable monomers for forming units of general formula (II) include, for example, the following:

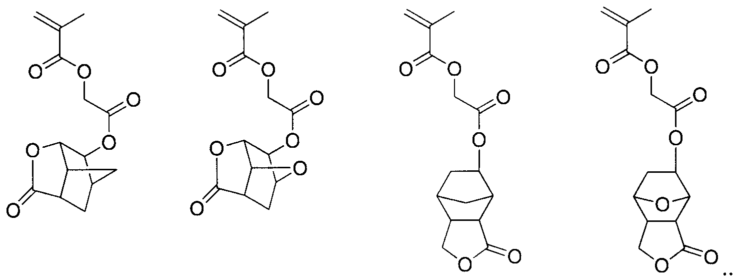

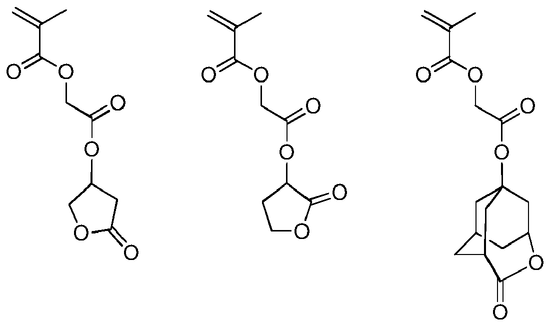

The unit of formula (III) provides a polar group, which enhances etch resistance of the matrix polymer and photoresist composition and provides additional means to control the dissolution rate of the matrix polymer and photoresist composition. This unit is formed from a 3-hydroxy-1-adamantyl acrylate (HADA) monomer.

The matrix polymer can include one or more additional units of general formulae (I), (II) and/or (III) different from the first units. Where additional such units are present in the matrix polymer, they will preferably include an additional leaving group-containing unit of formula (I) and/or a lactone-containing unit of formula (II). In addition to the polymerized units described above, the matrix polymer can include one or more additional units which are not of general formula (I), (II) or (III). Typically, the additional units will include the same or similar polymerizable group as those used for the monomers used to form the units of general formula (I), (II) or (III), but may include other, different polymerizable groups in the same polymer backbone, such as those which contain polymerized units of vinyl or a non-aromatic cyclic olefin (endocyclic double bond) such as an optionally substituted norbornene. For imaging at sub-200nm wavelengths such as 193 nm, the matrix polymer is typically substantially free (e.g., less than 15 mole%) of phenyl, benzyl or other aromatic groups where such groups are highly absorbing of the radiation. Suitable additional monomeric units for the polymer include, for example, one or more of the following: monomeric units containing ethers, lactones or esters, such as 2-methyl-acrylic acid tetrahydro-furan-3-yl ester, 2-methyl-acrylic acid 2-oxo-tetrahydro-furan-3-yl ester, 2-methyl-acrylic acid 5-oxo-tetrahydrofuran-3-yl ester, 2-methyl-acrylic acid 3-oxo-4,10-dioxa-tricyclo [5.2.1.02,6] dec-8-yl ester, 2-methyl-acrylic acid 3-oxo-4-oxa-tricyclo [5.2.1.02,6] dec-8-yl ester, 2-methyl-acrylic acid 5-oxo-4-oxa-tricyclo [4.2.1.03,7] non-2-yloxycarbonylmethyl ester, acrylic acid 3-oxo-4-oxa-tricyclo [5.2.1.02,6] dec-8-yl ester, 2-methyl-acrylic acid 5-oxo-4-oxa-tricyclo [4.2.1.03,7] non-2-yl ester, and 2-methyl-acrylic acid tetrahydro-furan-3-yl ester; monomeric units having polar groups such as alcohols and fluorinated alcohols, such as 2-methyl-acrylic acid 3-hydroxy-adamantan-1-yl ester, 2-methyl-acrylic acid 2-hydroxy-ethyl ester, 6-vinyl-naphthalen-2-ol, 2-methyl-acrylic acid 3,5-dihydroxy-adamantan-1-yl ester, 2-methyl-acrylic acid 6-(3,3,3-trifluoro-2-hydroxy-2-trifluoromethyl-propyl)-bicyclo [2.2.1] hept-2-yl, and 2-bicyclo [2.2.1] hept-5-en-2-ylmethyl-1,1,1,3,3,3-hexafluoro-propan-2-ol; monomeric units having acid labile moieties, for example, ester groups that contain a tertiary non-cyclic alkyl carbon such as t-butyl, or a tertiary alicyclic carbon such as methyladamantyl or ethylfenchyl covalently linked to a carboxyl oxygen of an ester of the polymer, 2-methyl-acrylic acid 2-(1-ethoxy-ethoxy)-ethyl ester, 2-methyl-acrylic acid 2-ethoxymethoxy-ethyl ester, 2-methyl-acrylic acid 2-methoxymethoxy-ethyl ester, 2-(1-ethoxy-ethoxy)-6-vinyl-naphthalene, 2-ethoxymethoxy-6-vinyl-naphthalene, and 2-methoxymethoxy-6-vinyl-naphthalene. The additional units if used are typically present in the polymer in an amount of from 10 to 30 mol%.

Exemplary preferred first matrix polymers include, for example, the following: 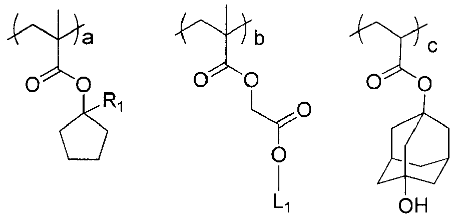 wherein: 0.3<a<0.7; 0.3<b<0.6; and 0.1<c<0.3; ; R₁ represents a C₁ to C₃ alkyl group; and L₁ represents a lactone group; 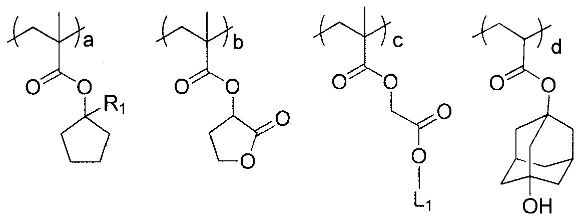 wherein: 0.3<a<0.7; 0.1<b<0.4; 0.1<c<0.4, and 0.1<d<0.3; R₁ represents a C₁ to C₃ alkyl group; and L₁ represents a lactone group; 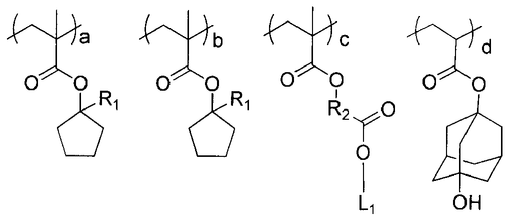 wherein: 0.1<a<0.5; 0.1<b<0.5; 0.2<c<0.6; and 0.1<d<0.3; R₁ independently represents a C₁ to C₃ alkyl group; R₂ represents a C₁ to C₃ alkylene group; and L₁ represents a lactone group; and

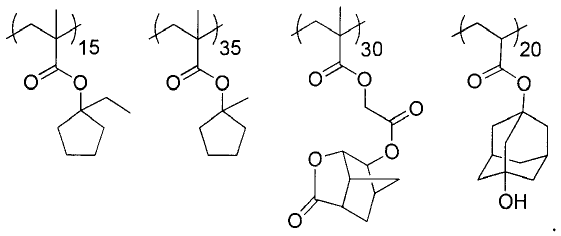

The first matrix polymer is present together with the second matrix polymer in the resist composition in an amount sufficient to obtain a uniform coating of desired thickness. Typically, the first matrix polymer is present in the composition in an amount of from 70 to 95 wt% based on total solids of the resist composition. Because of improved dissolution properties of the first matrix polymer in organic developers, useful molecular weights for the matrix polymer are not limited to lower values, but cover a very broad range. For example, the weight average molecular weight M_{w} of the polymers is typically less than 100,000, for example, from 5000 to 50,000, more typically from 6000 to 30,000 or from 7,000 to 25,000.

Suitable monomers used in forming the matrix polymers are commercially available and/or can be synthesized using known methods. The matrix polymers can readily be synthesized by persons skilled in the art using the monomers with known methods and other commercially available starting materials.

### B. Second Polymer

The photoresist compositions further include a second matrix polymer that has a high T_{g} and slow dissolution rate relative to the first matrix polymer. The second is believed to help minimize or prevent the occurrence of missing contact holes at small CD and pitch in a formed resist pattern. The second polymer comprises units of the following general formulae (IV) and (V): 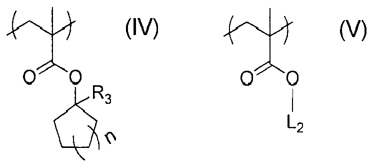 wherein: R₃ represents a C₁ to C₃ alkyl group; L₂ represents a lactone group; and n is 0 or 1.

The unit of general formula (IV) includes an acid labile group that undergoes a photoacid-promoted deprotection reaction on exposure to activating radiation and heat treatment. Suitable monomers for forming the units of formula (IV) are described above with respect to the unit of formula (I) in the matrix polymer.

The unit of general formula (V) includes a lactone moiety, providing a means for controlling dissolution rate of the second matrix polymer and photoresist composition. The following exemplary monomers are suitable for use in forming the additional lactone containing unit of general formula (V):

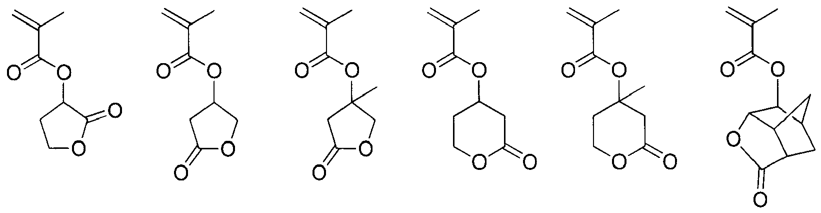

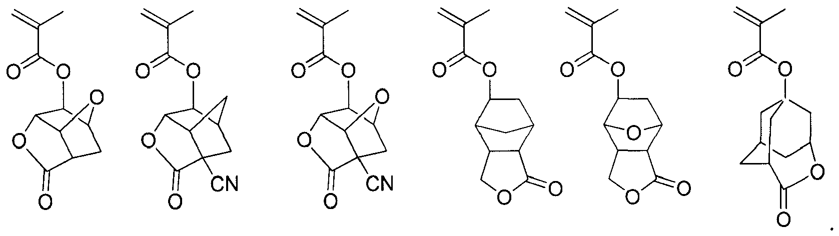

Preferably, L₂ in the unit of general formula (V) is chosen from the following lactone groups:

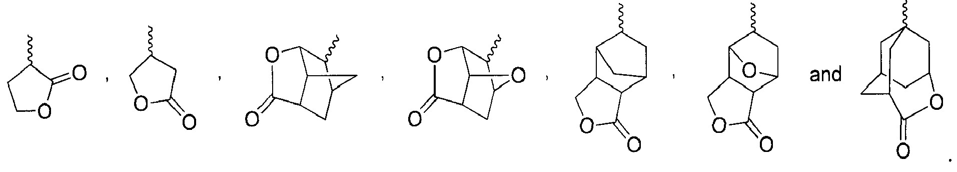

The second polymer can include one or more additional units of general formulae (IV) and/or (V) which are different from the first units. In addition to the polymerized units described above, the second matrix polymer can include one or more additional units, for example, units formed from hydroxy adamantyl methacrylate.

Exemplary preferred second polymers include, for example, the following: 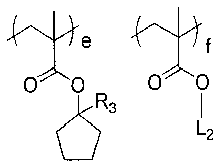 wherein: 0.4 < e < 0.6; and 0.4 < f < 0.6; and 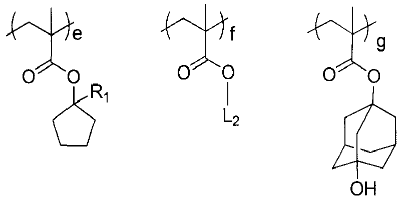 wherein: 0.3<e<0.7; 0.3<f<0.6; and 0.1<g<0.3.

The second polymer is present in the resist composition in an amount, together with the first matrix polymer, sufficient to obtain a uniform coating of desired thickness. Typically, the second polymer is present in the composition in an amount of from 30 to 70 wt%, preferably from 40 to 60 wt%, based on total solids of the resist composition. The weight average molecular weight M_{w} of the second polymer is typically relatively low, for example, less than 13,000, for example, from 6000 to 12,000, more typically from 8000 to 12,000.

Suitable monomers used in forming the second polymer are commercially available and/or can be synthesized using known methods. The second polymer can readily be synthesized by persons skilled in the art using the monomers with known methods and other commercially available starting materials.

### C. Optional Additive Polymer

The photoresist compositions can include an optional additive polymer that is a C₃ to C₇ alkyl (meth)acrylate, preferably methacrylate, homopolymer or copolymer. The additive polymer can be linear, branched or cyclic. The additive polymer has a lower surface energy than that of the matrix polymer and second polymer, and should be substantially non-miscible with the matrix and second polymers. A typical surface free energy of the additive polymer is from 10 to 40 mJ/m². In this way, segregation or migration of the first additive to the top or upper portions of an applied photoresist layer during the coating process to form a surface layer substantially made up of the additive polymer can be facilitated. Following exposure and post exposure bake (PEB), the resist coating layer is developed in a developer, typically an organic solvent. The developer removes unexposed regions of the photoresist layer and the surface layer of the exposed regions. It is believed that removal of the surface layer of the exposed resist portions provides improved resist profiles as a result of the reduction in surface inhibition. Also a result of the additive polymer's surface migration, the photoresist composition layer can, in the case of an immersion lithography process, effectively inhibit migration of photoresist materials out of the resist layer into the immersion fluid.

The additive polymer is preferably acid-insensitive. This means that the additive polymer as part of a layer of the photoresist composition does not react with acid generated from the photoacid generator following softbake, exposure to activating radiation and post exposure bake. The additive polymer should therefore be free of photoacid-labile groups, such as photoacid-labile ester or acetal groups, which groups are typically included in matrix polymers. As a result of the additive polymer's migration to the resist surface during coating and its acid-inactivity, micro-bridge defects in trench formation and missing contact hole defects caused by the presence of stray light in regions of the resist blocked by a photomask can be minimized or avoided.

The additive polymer is preferably free of silicon and fluorine. Silicon-containing polymers exhibit a significantly lower etch rate than organic photoresist polymers in certain etchants. As a result, aggregation of a silicon-containing additive polymer at the surface of an organic matrix polymer-based resist layer can cause cone defects during the etching process. It is therefore desired that the additive polymer not contain silicon. Avoidance of fluorine-containing additive polymers is similarly desired. In this regard, the hydrophobic nature of certain fluorine-based polymers can be problematic as a result of their limited solubility in organic solvents useful in negative tone development. As well, it is desired to reduce the use of fluorinated materials for environmental purposes.

Preferred additive polymers are soluble in the same organic solvent(s) used to formulate the photoresist composition. Preferred additive polymers also will be soluble or become soluble upon post exposure bake (e.g., 120°C for 60 seconds) in organic developers used in negative tone development processes.

Suitable additive polymers and monomers for making the additive polymers for use in the Attorney Docket No. 70875 photoresist compositions of the invention are commercially available and/or can be made by persons skilled in the art. Exemplary suitable monomers useful in making the additive polymer are described below, but are not limited to these structures. Optionally, two or more different polymerized units of the following monomers can be employed to provide a copolymer.

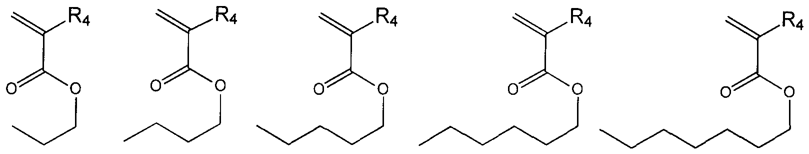

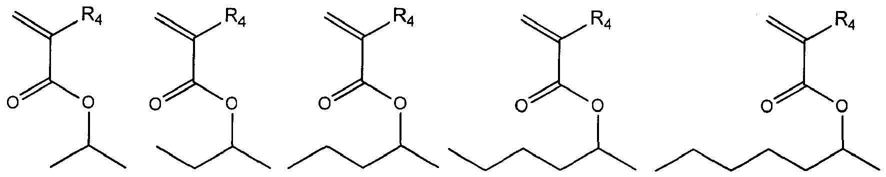

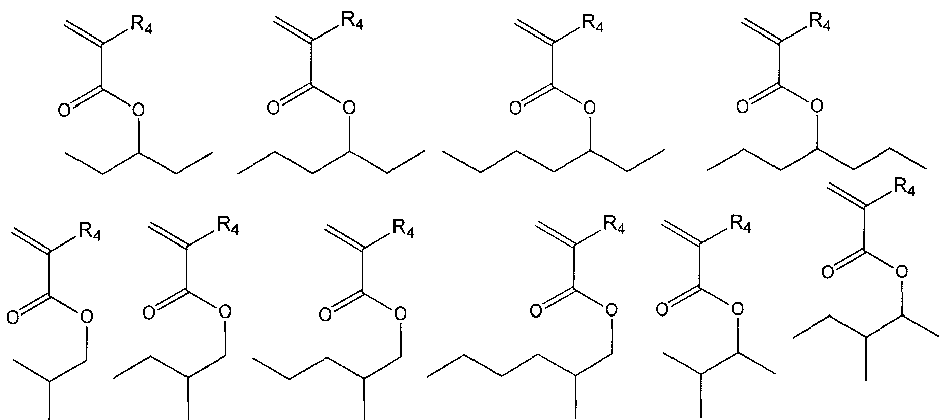

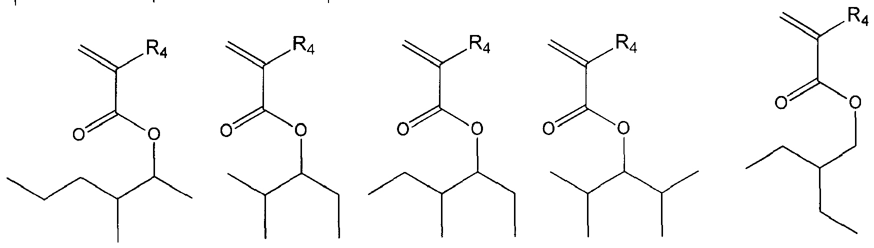

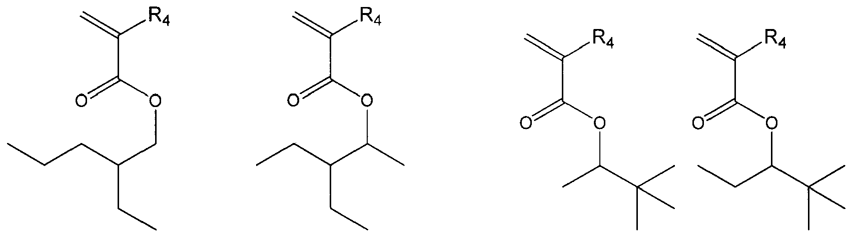

In the above formulas, R₄ is hydrogen or methyl. Preferred polymer additives include, for example, poly(n-butyl acrylate), poly(n-butyl methacrylate), poly(i-butyl acrylate), poly(i-butyl methacrylate), poly(t-butyl acrylate) and poly(t-butyl methacrylate). The one or more additive polymer typically may be present in the photoresist composition in relatively small amounts and still provide effective results. The content of the additive polymer may depend, for example, on whether the lithography is a dry or immersion-type process. For example, the additive polymer lower limit for immersion lithography is generally dictated by the need to prevent leaching of the resist components. A higher additive polymer content will typically result in pattern degradation. The one or more polymer additive is typically present in the compositions of the invention in an amount of from 0.1 to 10 wt%, more typically from 1 to 5 wt%, based on total solids of the photoresist composition. The weight average molecular weight of the additive polymer is typically less than 400,000, for example from 5000 to 50,000.

### D. Photoacid Generator

The photosensitive composition further comprises a photoacid generator (PAG) employed in an amount sufficient to generate a latent image in a coating layer of the composition upon exposure to activating radiation. For example, the photoacid generator will suitably be present in an amount of from about 1 to 20 wt% based on total solids of the photoresist composition. Typically, lesser amounts of the PAG will be suitable for chemically amplified resists as compared with non-chemically amplified materials.

Suitable PAGs are known in the art of chemically amplified photoresists and include, for example: onium salts, for example, triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate; nitrobenzyl derivatives, for example, 2-nitrobenzyl-p-toluenesulfonate, 2,6-dinitrobenzyl-p-toluenesulfonate, and 2,4-dinitrobenzyl-p-toluenesulfonate; sulfonic acid esters, for example, 1,2,3-tris(methanesulfonyloxy)benzene, 1,2,3-tris(trifluoromethanesulfonyloxy)benzene, and 1,2,3-tris(p-toluenesulfonyloxy)benzene; diazomethane derivatives, for example, bis(benzenesulfonyl)diazomethane, bis(p-toluenesulfonyl)diazomethane; glyoxime derivatives, for example, bis-O-(p-toluenesulfonyl)-α-dimethylglyoxime, and bis-O-(n-butanesulfonyl)-α-dimethylglyoxime; sulfonic acid ester derivatives of an N-hydroxyimide compound, for example, N-hydroxysuccinimide methanesulfonic acid ester, N-hydroxysuccinimide trifluoromethanesulfonic acid ester; and halogen-containing triazine compounds, for example, 2-(4-methoxyphenyl)-4,6-bis(trichloromethyl)-1,3,5-triazine, and 2-(4-methoxynaphthyl)-4,6-bis(trichloromethyl)-1,3,5-triazine. One or more of such PAGs can be used.

### E. Solvent

Suitable solvents for the photoresist compositions of the invention include, for example: glycol ethers such as 2-methoxyethyl ether (diglyme), ethylene glycol monomethyl ether, and propylene glycol monomethyl ether; propylene glycol monomethyl ether acetate; lactates such as methyl lactate and ethyl lactate; propionates such as methyl propionate, ethyl propionate, ethyl ethoxy propionate and methyl-2-hydroxy isobutyrate; Cellosolve esters such as methyl Cellosolve acetate; aromatic hydrocarbons such as toluene and xylene; and ketones such as acetone, methylethyl ketone, cyclohexanone and 2-heptanone. A blend of solvents such as a blend of two, three or more of the solvents described above also are suitable. The solvent is typically present in the composition in an amount of from 90 to 99 wt%, more typically from 95 to 98 wt%, based on the total weight of the photoresist composition.

### F. Other Components

The photoresist compositions can also include other optional materials. For example, the compositions can include one or more of actinic and contrast dyes, anti-striation agents, plasticizers, speed enhancers, sensitizers, and the like. Such optional additives if used are typically present in the composition in minor amounts such as from 0.1 to 10 wt% based on total solids of the photoresist composition.

A preferred optional additive of resist compositions of the invention is an added base, for example, a caprolactam, which can enhance resolution of a developed resist relief image. Other suitable basic additives include: alkyl amines such as tripropylamine and dodecylamine, aryl amines such as diphenylamine, triphenylamine, aminophenol, 2-(4-aminophenyl)-2-(4-hydroxyphenyl)propane, and the like. The added base is suitably used in relatively small amounts, for example, from 0.01 to 5 wt%, preferably from 0.1 to 2 wt%, based on total solids of the photoresist composition.

### Preparation of Photoresist Compositions

The photoresists used in accordance with the invention are generally prepared following known procedures. For example, a photoresist composition of the invention can be prepared by dissolving the solid components of the photoresist in the solvent component. The desired total solids content of the photoresist will depend on factors such as the particular polymers in the composition, final layer thickness and exposure wavelength. Typically the solids content of the photoresist varies from 1 to 10 wt%, more typically from 2 to 5 wt%, based on the total weight of the photoresist composition.

Photoresist compositions of the invention find particular applicability in negative-tone development processes such as described below.

### Negative Tone Development Methods

The invention further provides methods for forming a photoresist relief image and producing an electronic device using photoresists of the invention. The invention also provides novel articles of manufacture comprising substrates coated with a photoresist composition of the invention. Processes in accordance with the invention will now be described with reference to FIG. 1A-E, which illustrates an exemplary process flow for forming a photolithographic pattern by negative tone development.

FIG. 1A depicts in cross-section a substrate 100 which may include various layers and features. The substrate can be of a material such as a semiconductor, such as silicon or a compound semiconductor (e.g., III-V or II-VI), glass, quartz, ceramic, copper and the like. Typically, the substrate is a semiconductor wafer, such as single crystal silicon or compound semiconductor wafer, and may have one or more layers and patterned features formed on a surface thereof. One or more layers to be patterned 102 may be provided over the substrate 100. Optionally, the underlying base substrate material itself may be patterned, for example, when it is desired to form trenches in the substrate material. In the case of patterning the base substrate material itself, the pattern shall be considered to be formed in a layer of the substrate.

The layers may include, for example, one or more conductive layers such as layers of aluminum, copper, molybdenum, tantalum, titanium, tungsten, alloys, nitrides or silicides of such metals, doped amorphous silicon or doped polysilicon, one or more dielectric layers such as layers of silicon oxide, silicon nitride, silicon oxynitride, or metal oxides, semiconductor layers, such as single-crystal silicon, and combinations thereof. The layers to be etched can be formed by various techniques, for example, chemical vapor deposition (CVD) such as plasma-enhanced CVD, low-pressure CVD or epitaxial growth, physical vapor deposition (PVD) such as sputtering or evaporation, or electroplating. The particular thickness of the one or more layers to be etched 102 will vary depending on the materials and particular devices being formed.

Depending on the particular layers to be etched, film thicknesses and photolithographic materials and process to be used, it may be desired to dispose over the layers 102 a hard mask layer 104 and/or a bottom antireflective coating (BARC) 106 over which a photoresist layer 108 is to be coated. Use of a hard mask layer 104 may be desired, for example, with very thin resist layers, where the layers to be etched require a significant etching depth, and/or where the particular etchant has poor resist selectivity. Where a hard mask layer is used, the resist patterns to be formed can be transferred to the hard mask layer which, in turn, can be used as a mask for etching the underlying layers 102. Suitable hard mask materials and formation methods are known in the art. Typical materials include, for example, tungsten, titanium, titanium nitride, titanium oxide, zirconium oxide, aluminum oxide, aluminum oxynitride, hafnium oxide, amorphous carbon, silicon oxynitride and silicon nitride. The hard mask layer 104 can include a single layer or a plurality of layers of different materials. The hard mask layer can be formed, for example, by chemical or physical vapor deposition techniques.

A bottom antireflective coating 106 may be desirable where the substrate and/or underlying layers would otherwise reflect a significant amount of incident radiation during photoresist exposure such that the quality of the formed pattern would be adversely affected. Such coatings can improve depth-of-focus, exposure latitude, linewidth uniformity and CD control. Antireflective coatings are typically used where the resist is exposed to deep ultraviolet light (300 nm or less), for example, KrF excimer laser light (248nm) or ArF excimer laser light (193 nm). The antireflective coating 106 can comprise a single layer or a plurality of different layers. Suitable antireflective materials and methods of formation are known in the art. Antireflective materials are commercially available, for example, those sold under the AR™ trademark by Rohm and Haas Electronic Materials LLC (Marlborough, MA USA), such as AR™40A and AR™124 antireflectant materials.

A photoresist composition as described herein is applied on the substrate over the antireflective layer 106 (if present) to form a photoresist layer 108. The photoresist composition can be applied to the substrate by spin-coating, dipping, roller-coating or other conventional coating technique. Of these, spin-coating is typical. For spin-coating, the solids content of the coating solution can be adjusted to provide a desired film thickness based upon the specific coating equipment utilized, the viscosity of the solution, the speed of the coating tool and the amount of time allowed for spinning. A typical thickness for the photoresist layer 108 is from about 500 to 3000 Å.

The photoresist layer can next be softbaked to minimize the solvent content in the layer, thereby forming a tack-free coating and improving adhesion of the layer to the substrate. The softbake can be conducted on a hotplate or in an oven, with a hotplate being typical. The softbake temperature and time will depend, for example, on the particular material of the photoresist and thickness. Typical softbakes are conducted at a temperature of from about 90 to 150°C, and a time of from about 30 to 90 seconds.

The photoresist layer 108 is next exposed to activating radiation 110 through a first photomask 112 to create a difference in solubility between exposed and unexposed regions. References herein to exposing a photoresist composition to radiation that is activating for the composition indicates that the radiation is capable of forming a latent image in the photoresist composition. The photomask has optically transparent and optically opaque regions 113, 114 corresponding to regions of the resist layer to remain and be removed, respectively, in a subsequent development step for a positive-acting material as illustrated. The exposure wavelength is typically sub-400 nm, sub-300 nm or sub-200 nm, for example, 248 nm, 193 nm or EUV wavelengths (e.g., 13.5 nm). The methods find use in immersion or dry (non-immersion) lithography techniques. The exposure energy is typically from about 10 to 80 mJ/cm², dependent upon the exposure tool and the components of the photosensitive composition.

As shown in FIG. 1B, the exposed resist layer is made up of unexposed and exposed regions 108a, 108b. Following exposure of the photoresist layer 108, a post-exposure bake (PEB) is performed. The PEB can be conducted, for example, on a hotplate or in an oven. Conditions for the PEB will depend, for example, on the particular photoresist composition and layer thickness. The PEB is typically conducted at a temperature of from about 80 to 150°C, and a time of from about 30 to 90 seconds.

The exposed photoresist layer is next developed to remove unexposed regions 108a, leaving exposed regions 108b forming a resist pattern as shown in FIG. 1C. The developer is typically an organic developer, for example, a solvent chosen from ketones, esters, ethers, hydrocarbons, and mixtures thereof. Suitable ketone solvents include, for example, acetone, 2-hexanone, 5-methyl-2-hexanone, 2-heptanone, 4-heptanone, 1-octanone, 2-octanone, 1-nonanone, 2-nonanone, diisobutyl ketone, cyclohexanone, methylcyclohexanone, phenylacetone, methyl ethyl ketone and methyl isobutyl ketone. Suitable ester solvents include, for example, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate and propyl lactate. Suitable ether solvents include, for example, dioxane, tetrahydrofuran and glycol ether solvents, for example, ethylene glycol monomethyl ether, propylene glycol monomethyl ether, ethylene glycol monoethyl ether, propylene glycol monoethyl ether, diethylene glycol monomethyl ether, triethylene glycol monoethyl ether and methoxymethyl butanol. Suitable amide solvents include, for example, N-methyl-2-pyrrolidone, N,N-dimethylacetamide and N,N-dimethylformamide. Suitable hydrocarbon solvents include, for example, aromatic hydrocarbon solvents such as toluene and xylene. In addition, mixtures of these solvents, or one or more of the listed solvents mixed with a solvent other than those described above or mixed with water can be used. Other suitable solvents include those used in the photoresist composition. The developer is preferably 2-heptanone or a butyl acetate such as n-butyl acetate.

Mixtures of organic solvents can preferably be employed as a developer, for example, a mixture of a first and second organic solvent. The first organic solvent can be chosen from hydroxy alkyl esters such as methyl-2-hydroxyisobutyrate and ethyl lactate; and linear or branched C₅ to C₆ alkoxy alkyl acetates such as propylene glycol monomethyl ether acetate (PGMEA). Of the first organic solvents, 2-heptanone and 5-methyl-2-hexanone are preferred. The second organic solvent can be chosen from linear or branched unsubstituted C₆ to C₈ alkyl esters such as n-butyl acetate, n-pentyl acetate, n-butyl propionate, n-hexyl acetate, n-butyl butyrate and isobutyl butyrate; and linear or branched C₈ to C₉ ketones such as 4-octanone, 2,5-dimethyl-4-hexanone and 2,6-dimethyl-4-heptanone. Of the second organic solvents, n-butyl acetate, n-butyl propionate and 2,6-dimethyl-4-heptanone are preferred. Preferred combinations of the first and second organic solvent include 2-heptanone/n-butyl propionate, cyclohexanone/n-butyl propionate, PGMEA/n-butyl propionate, 5-methyl-2-hexanone/n-butyl propionate, 2-heptanone/2,6-dimethyl-4-heptanone and 2-heptanone/n-butyl acetate. Of these, 2-heptanone/n-butyl acetate and 2-heptanone/n-butyl propionate are particularly preferred.

The organic solvents are typically present in the developer in a combined amount of from 90 wt% to 100 wt%, more typically greater than 95 wt%, greater than 98 wt% , greater than 99 wt% or 100 wt%, based on the total weight of the developer.

The developer material may include optional additives, for example, surfactants such as described above with respect to the photoresist. Such optional additives typically will be present in minor concentrations, for example, in amounts of from about 0.01 to 5 wt% based on the total weight of the developer.

The developer can be applied to the substrate by known techniques, for example, by spin-coating or puddle-coating. The development time is for a period effective to remove the unexposed regions of the photoresist, with a time of from 5 to 30 seconds being typical. Development is typically conducted at room temperature. The development process can be conducted without use of a cleaning rinse following development. In this regard, it has been found that the development process can result in a residue-free wafer surface rendering such extra rinse step unnecessary.

The BARC layer 106, if present, is selectively etched using resist pattern 108b as an etch mask, exposing the underlying hardmask layer 104. The hardmask layer is next selectively etched, again using the resist pattern 108b as an etch mask, resulting in patterned BARC and hardmask layers 106', 104', as shown in FIG. 1D. Suitable etching techniques and chemistries for etching the BARC layer and hardmask layer are known in the art and will depend, for example, on the particular materials of these layers. Dry-etching processes such as reactive ion etching are typical. The resist pattern 108b and patterned BARC layer 106' are next removed from the substrate using known techniques, for example, oxygen plasma ashing.

Using the hardmask pattern 104' as an etch mask, the one or more layers 102 are selectively etched. Suitable etching techniques and chemistries for etching the underlying layers 102 are known in the art, with dry-etching processes such as reactive ion etching being typical. The patterned hardmask layer 104' can next be removed from the substrate surface using known techniques, for example, a dry-etching process such as reactive ion etching. The resulting structure is a pattern of etched features 102' as illustrated in FIG. 1E. In an alternative exemplary method, it may be desirable to pattern the layer 102 directly using the resist pattern 108b without the use of a hardmask layer 104. Whether direct patterning is employed will depend on factors such as the materials involved, resist selectivity, resist pattern thickness and pattern dimensions.

The negative tone development methods of the invention are not limited to the exemplary methods described above. For example, the photoresist compositions of the invention can be used in a negative tone development double exposure method for making contact holes. An exemplary such process is a variation of the technique described with reference to FIG. 1, but using an additional exposure of the photoresist layer in a different pattern than the first exposure. In this process, the photoresist layer is exposed to actinic radiation through a photomask in a first exposure step. The photomask includes a series of parallel lines forming the opaque regions of the mask. Following the first exposure, a second exposure of the photoresist layer is conducted through a second photomask that includes a series of lines in a direction perpendicular to those of the first photomask. The resulting photoresist layer includes unexposed regions, once-exposed regions and twice-exposed regions.

Following the second exposure, the photoresist layer is post-exposure baked and developed using a developer as described above. Unexposed regions corresponding to points of intersection of the lines of the two masks are removed, leaving behind the once- and twice-exposed regions of the resist. The resulting structure can next be patterned as described above with reference to FIG. 1. This method is particularly suited to formation of contact holes in the manufacture of electronic devices.

The negative tone development methods of the invention are not limited to the exemplary methods described above. For example, the photoresist compositions of the invention can be used in a negative tone development double exposure method for making contact holes. An exemplary such process is a variation of the technique described with reference to FIG. 1, but using an additional exposure of the photoresist layer in a different pattern than the first exposure. In this process, the photoresist layer is exposed to actinic radiation through a photomask in a first exposure step. The photomask includes a series of parallel lines forming the opaque regions of the mask. Following the first exposure, a second exposure of the photoresist layer is conducted through a second photomask that includes a series of lines in a direction perpendicular to those of the first photomask. The resulting photoresist layer includes unexposed regions, once-exposed regions and twice-exposed regions. Following the second exposure, the photoresist layer is post-exposure baked and developed using a developer as described above. Unexposed regions corresponding to points of intersection of the lines of the two masks are removed, leaving behind the once- and twice-exposed regions of the resist. The resulting structure can next be patterned as described above with reference to FIG. 1. This method is particularly suited to formation of contact holes in the manufacture of electronic devices.

### EXAMPLES

### Matrix Polymer Synthesis

The following monomers were employed in the syntheses of copolymers used in the Examples.

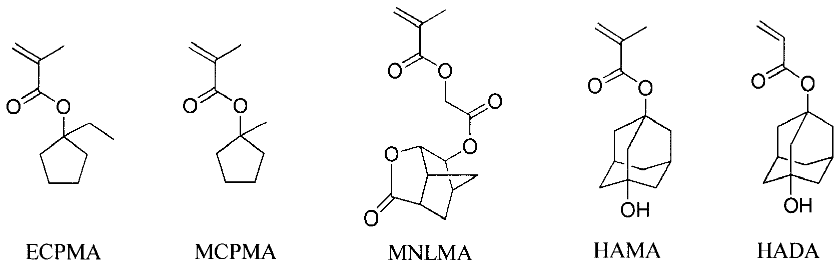

### Example 1: Synthesis of poly(ECPMA/MCPMA/MNLMA/HADA) (P-1)

Monomers of ECPMA (5.092 g), MCPMA (10.967 g), MNLMA (15.661 g) and HADA (8.280 g) were dissolved in 60 g of propylene glycol monomethyl ether acetate (PGMEA). The monomer solution was degassed by bubbling with nitrogen for 20 min. PGMEA (27.335 g) was charged into a 500 mL three-neck flask equipped with a condenser and a mechanical stirrer and was degassed by bubbling with nitrogen for 20 min. Subsequently the solvent in the reaction flask was brought to a temperature of 80 °C. V601 (dimethyl-2,2-azodiisobutyrate) (0.858 g) was dissolved in 8 g of PGMEA and the initiator solution was degassed by bubbling with nitrogen for 20 min. The initiator solution was added into the reaction flask and then monomer solution was fed into the reactor dropwise over a 3 h period under rigorous stirring and nitrogen environment. After monomer feeding was complete, the polymerization mixture was left standing for an additional hour at 80 °C. After a total of 4 h of polymerization time (3 h of feeding and 1 h of post-feeding stirring), the polymerization mixture was allowed to cool to room temperature. Precipitation was carried out in methyl tert-butyl ether (MTBE) (1634 g). The precipitated polymer was collected by filtration, air-dried overnight, re-dissolved in 120 g of THF, and re-precipitated into MTBE (1634 g). The final polymer was filtered, air-dried overnight and further dried under vacuum at 60 °C for 48 h to give the following polymer (Mw = 20,120 and Mw/Mn = 1.59):

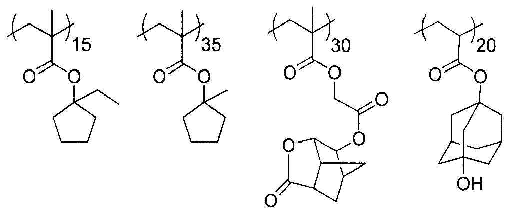

### Example 2: Synthesis of poly(MCPMA/NLM) (P-2)

Monomers of MCPMA (17.234 g) and NLM (22.766 g) were dissolved in 60 g of PGMEA. The monomer solution was degassed by bubbling with nitrogen for 20 min. PGMEA (31.938 g) was charged into a 500 mL three-neck flask equipped with a condenser and a mechanical stirrer and was degassed by bubbling with nitrogen for 20 min. Subsequently, the solvent in the reaction flask was brought to a temperature of 80 °C. V601 (dimethyl-2,2-azodiisobutyrate) (2.831 g) was dissolved in 8 g of PGMEA and the initiator solution was degassed by bubbling with nitrogen for 20 min. The initiator solution was added into the reaction flask and then monomer solution was fed into the reactor dropwise over a 3 h period under rigorous stirring and nitrogen environment. After monomer feeding was complete, the polymerization mixture was left standing for an additional hour at 80 °C. After a total of 4 h of polymerization time (3 h of feeding and 1 h of post-feeding stirring), the polymerization mixture was allowed to cool to room temperature. Precipitation was carried out in methyl tert-butyl ether (MTBE) (1713 g). The precipitated polymer was collected by filtration, air-dried overnight, re-dissolved in 120 g of THF and re-precipitated into MTBE (1713 g). The final polymer was filtered, air-dried overnight and further dried under vacuum at 60 °C for 48 h to give the following polymer (Mw = 8,060 and Mw/Mn = 1.46):

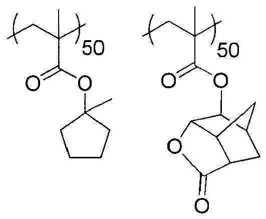

### Examples 3-6

Additional polymers were synthesized using the procedures set forth above with respect to Example 1 using the monomers and ratios as set forth in Table 1.

**TABLE 1.**

| Ex. | Polymer | Monomers | Composition* | Mw | Mw/Mn |
|---|---|---|---|---|---|
| 1 | P-1 | ECPMA/MCPMA/MNLMA/HADA | 15/35/30/20 | 20,120 | 1.59 |
| 2 | P-2 | MCPMA/NLM | 50/50 | 8,060 | 1.46 |
| 3 | P-3 | ECPMA/MNLMA/HAMA | 50/30/20 | 10,904 | 1.44 |
| 4 | P-4 | MCPMA/MNLMA/HAMA | 50/30/20 | 10,918 | 1.42 |
| 5 | P-5 | MCPMA/MNLMA/HAMA | 50/30/20 | 9,635 | 1.41 |
| 6 | P-6 | MCPMA/MNLMA/HAMA | 40/40/20 | 8,991 | 1.46 |

| | | | | | |
|---|---|---|---|---|---|
| *Molar feed ratio in the polymerization | | | | | |

### Additive Polymer Synthesis: Poly(n-butyl methacrylate) (PnBMA)

40 g of n-butyl methacrylate was dissolved in 60 g of PGMEA. The monomer solution was degassed by bubbling with nitrogen for 20 min. PGMEA (35.913 g) was charged into a 500 mL three-neck flask equipped with a condenser and a mechanical stirrer and was degassed by bubbling with nitrogen for 20 min. Subsequently, the solvent in the reaction flask was brought to a temperature of 80 °C. V601 (dimethyl-2,2-azodiisobutyrate) (1.295 g) was dissolved in 8 g of PGMEA and the initiator solution was degassed by bubbling with nitrogen for 20 min. The initiator solution was added into the reaction flask and then monomer solution was fed into the reactor dropwise over a 3 h period under rigorous stirring and nitrogen environment. After monomer feeding was complete, the polymerization mixture was left standing for an additional hour at 80 °C. After a total of 4 h of polymerization time (3 h of feeding and 1 h of post-feeding stirring), the polymerization mixture was allowed to cool to room temperature. Precipitation was carried out in methanol/water (8/2) mixture (1781 g). The precipitated polymer was collected by filtration, re-dissolved in 120 g of THF, and re-precipitated into methanol/water (8/2) mixture (1781 g). The final polymer was filtered and dried under vacuum at 60 °C for 48 h to give 31.5 g of PnBMA (Mw = 17,600 and Mw/Mn = 1.80).

### Photoresist Composition Preparation

### Example 7

2.526 g of polymer P-1 was dissolved in 29.070 g of PGMEA, 19.380g of cyclohexanone, and 48.450 g of methyl-2-hydroxyisobutyrate. To this mixture was added 0.484 g of "PAG A" described below, 0.029 g of 1-(tert-butoxycarbonyl)-4-hydroxypiperidine quencher and 0.062 g of PnBMA. The resulting mixture was rolled on a roller for six hours and then filtered through a Teflon filter having a 0.2 micron pore size.

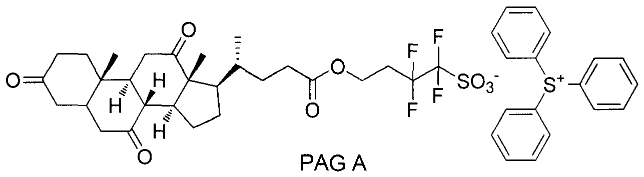

### Examples 8-13

Additional photoresist compositions were formulated using the procedures set forth above with respect to Example 7, with the materials and amounts as set forth in Table 2.

**TABLE 2**

| **Ex.** | **Polymer 1** | **Polymer 2** | **PnBMA** | **PAG** | **Quencher** | **Solv.A** | **Solv. B** | **Solv. C** |
|---|---|---|---|---|---|---|---|---|
| 7 (Comp.) | P-1 (2.526) | N/A | 0.062 | 0.484 | 0.029 | 29.070 | 19.380 | 48.450 |
| 8 (Comp.) | P-2 (2.526) | N/A | 0.062 | 0.484 | 0.029 | 29.070 | 19.380 | 48.450 |
| 9 | P-1 (1.263) | P-2 (1.263) | 0.062 | 0.484 | 0.029 | 29.070 | 19.380 | 48.450 |
| 10 | P-1 (1.263) | P-3 (1.263) | 0.062 | 0.484 | 0.029 | 29.070 | 19.380 | 48.450 |
| 11 | P-1 (1.263) | P-4 (1.263) | 0.062 | 0.484 | 0.029 | 29.070 | 19.380 | 48.450 |
| 12 | P-1 (1.263) | P-5 (1.263) | 0.062 | 0.484 | 0.029 | 29.070 | 19.380 | 48.450 |
| 13 | P-1 (1.263) | P-6 (1.263) | 0.062 | 0.484 | 0.029 | 29.070 | 19.380 | 48.450 |

Quencher: 1-(tert-butoxycarbonyl)-4-hydroxypiperidine; Solvent A: propylene glycol monomethyl ether acetate; Solvent B: cyclohexanone, Solvent C: methyl-2-hydroxyisobutyrate. All contents in grams. "Comp" = comparative example.

### Lithographic Evaluation

### Examples 14-20

300 mm silicon wafers were spin-coated with AR™40A antireflectant (Rohm and Haas Electronic Materials) to form a first bottom antireflective coating (BARC) on a TEL CLEAN TRACK™ LITHIUS™ i+ coater/developer. The wafer was baked for 60 seconds at 215 °C, yielding a first BARC film thickness of 840Å. A second BARC layer was next coated over the first BARC using AR™124 antireflectant (Rohm and Haas Electronic Materials), and was baked at 205 °C for 60 seconds to generate a 200Å top BARC layer. Photoresist formulations were then coated on the dual BARC-coated wafers and soft-baked (SB) at 90 °C for 60 seconds on a TEL CLEAN TRACK™ LITHIUS™ i+ coater/developer to provide a resist layer thickness of 900Å.

The photoresist-coated wafers were exposed through a mask on an ASML TWINSCAN™ XT:1900i immersion scanner using a dipole illumination with 1.35 NA, 0.97 outer sigma, 0.85 inner sigma and X polarization. Immediately after the first exposure step, the wafers were exposed again using a different mask with a dipole illumination with 1.35 NA, 0.97 outer sigma, 0.85 inner sigma and Y polarization. The exposed wafers were post-exposure baked at 90 °C for 60 seconds and then developed using 2-heptanone for 25 seconds on a TEL CLEAN TRACK™ LITHIUS™ i+ coater/developer to give negative tone patterns. Contact hole patterns were obtained with post patterns on the mask. Critical dimensions (CDs) were measured on a Hitachi CG4000 CD SEM at various mask CD and pitches. Optimum energy (*E*ₒp) to print 38 nm holes was calculated by plotting the CD values of contact holes as a function of exposure energy using a mask with 38 nm 1:1 line/space CD. CD uniformity (CDU) of 38 nm contact holes was measured as a 3σ of 270 hole CD values. For each wafer, 30 images per die and 9 contact hole measurements per image were taken at 250K magnification. The lithographic results are summarized in Table 2. The P-1 polymer resulted in good circularity, but missing contact holes were formed for 38 nm contact holes at 76nm pitch. While the P-2 polymer did not cause missing contact holes at the same CD and pitch, poor pattern fidelity was obtained. When these two polymers were blended as in Example 9, a synergetic effect was observed in resolution and excellent CDU was achieved (Example 16). It is believed that polymers having low T_{g} such as P-1 can offer good circularity but are more prone to missing contact hole formation at smaller CD and pitch. It is further believed that this can be addressed by blending this type of polymer with a polymer having a higher Tg. When the P-1 polymer was blended with similar methacrylic copolymers, 38 nm contact holes were formed without missing contact holes for 38 nm contact holes at 76 nm pitch.

**TABLE 3**

| **Ex.** | **Polymer 1** | **Polymer 2** | **Eop (MJ/cm²)** | **3σ CDU (nm)** |
|---|---|---|---|---|
| 14 (Comp.) | p-1 | N/A | 40.5 | N/A* |
| 15 (Comp.) | P-2 | N/A | 58.0 | N/A** |
| 16 | p-1 | P-2 | 45.0 | 4.15 |
| 17 | P-1 | P-3 | 36.6 | 4.38 |
| 18 | p-1 | P-4 | 46.0 | 5.20 |
| 19 | p-1 | P-5 | 47.5 | 5.13 |
| 20 | p-1 | P-6 | 44.5 | 5.29 |

| | | | | |
|---|---|---|---|---|
| *CDU was not measured due to missing contact holes at 38nm holes at 76nm pitch **CDU was not measured due to poor pattern fidelity at 38nm holes at 76nm pitch | | | | |

## Claims

1. A photoresist composition, comprising:
a first polymer comprising units of the following general formulae (I), (II) and (III): 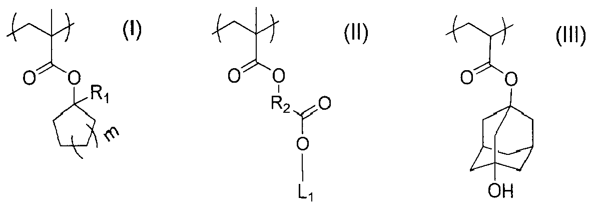 wherein: R₁ represents a C₁ to C₃ alkyl group; R₂ represents a C₁ to C₃ alkylene group; m represents 0 or 1; and L₁ represents a lactone group;
a second polymer comprising units of the following general formulae (IV) and (V): 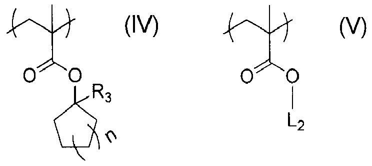 wherein: R₃ represents a C₁ to C₃ alkyl group; L₂ represents a lactone group; and n is 0 or 1; and
a photoacid generator.

2. The photoresist composition of claim 1, wherein the first polymer further comprises a second unit of general formulae (I), wherein R₁ in the first and second units of general formula (I) are different.

3. The photoresist composition of claim 2, wherein the first polymer is represented by the following general formula: 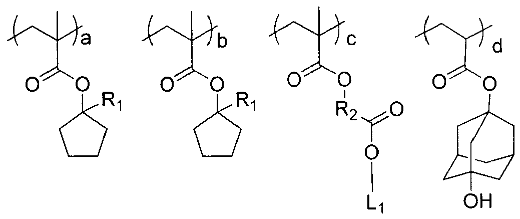 wherein: 0.3<a<0.7; 0.1 <b<0.4; 0.1 <c<0.4, and 0.1 <d<0.3

4. The photoresist composition of any of claims 1 to 3, wherein the second polymer is represented by the following general formula: 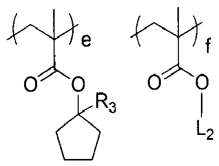 wherein: 0.4 < e < 0.6; and 0.4 < f < 0.6.

5. The photoresist composition of any of claims 1 to 3, wherein the second polymer further comprises a third unit represented by the following structure:

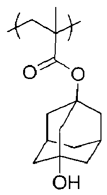

6. The photoresist composition of claim 5, wherein the second polymer is represented by the following general formula: 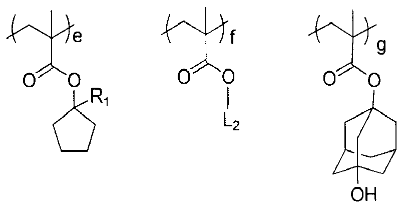 wherein: 0.3<e<0.7; 0.3<f<0.6; and 0.1<g<0.3.

7. The photoresist composition of any of claims 1 to 6, wherein L₁ and L₂ are independently chosen from the following lactone groups:

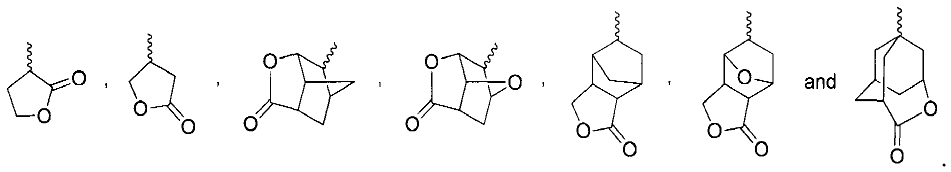

8. The photoresist composition of any of claims 1 to 7, further comprising a third polymer, wherein the third polymer is a poly(C₃ to C₇ alkyl methacrylate).

9. A coated substrate, comprising a substrate and a layer of a photoresist composition of any of claims 1 to 8 over a surface of the substrate.

10. A method of forming a photolithographic pattern, comprising:
(a) providing a substrate comprising one or more layer to be patterned over a surface of the substrate;
(b) applying a layer of a photoresist composition of any of claims 1 to 8 over the one or more layer to be patterned;
(c) patternwise exposing the photoresist composition layer to actinic radiation;
(d) heating the exposed photoresist composition layer in a post-exposure bake process; and
(e) applying a developer to the photoresist composition layer to remove a portion of the photoresist layer, thereby forming a photoresist pattern, wherein unexposed regions of the photoresist layer are removed by the developer to form the photoresist pattern.

11. The method of claim 10, wherein the developer comprises 2-heptanone.

12. The method of claim 10, wherein the developer comprises n-butyl acetate.
